# EUROPEAN PATENT APPLICATION

(11) **EP 4 737 871 A1**
(43) Date of publication of application: **06.05.2026**
(21) Application number: 25211006.9
(22) Date of filing: 24.10.2025
(51) Int. Cl.: G01J 5/00, C23C 16/52, C30B 25/16, G01J 5/04, G01J 5/061, G01J 5/08, C23C 16/32, G01J 5/05, H10P 72/00

(54) **DEVICE AND SYSTEM FOR IN-SITU SCANNING SUBSTRATE TEMPERATURE IN AN EPITAXIAL REACTOR**

(30) Priority: 29.10.2024 IT 202400024105
(71) Applicant: LPE S.p.A., 20021 Baranzate (MI) (IT)
(72) Inventor: MESCHIA, Maurilio, Asti (IT)
(74) Representative: Buzzi, Notaro & Antonielli d'Oulx S.p.A.

(57) **Abstract**

A temperature monitoring system for measuring the temperature of a substrate in a reactor comprising: (i) a reaction chamber suitable for the deposition of a film on a deposition surface of a substrate; (ii) a temperature monitoring device comprising an optical device, a remote sensing thermometer, and a supporting device. The remote sensing thermometer comprises at least one detector of IR radiation adapted for temperature measurements. The reaction chamber is provided with at least one aperture; the at least one optical device is adapted to: (i) intercept IR radiation emitted from at least one point of the deposition surface of the substrate through the aperture; and (ii) divert the intercepted IR radiation to the detector.

## Description

### FIELD OF INVENTION

The present invention relates to the field of temperature monitoring systems for measuring the temperature of a substrate during the deposition process in a reactor.

Additionally, though not exclusively, the present invention relates to the field of epitaxial deposition of semiconductor films on substrates; in particular to a reactor implementing a temperature monitoring system.

Furthermore, the present invention relates to the field of the deposition of silicon carbide and gallium nitride films on a semiconductor substrate in a hot-wall, crossflow, homoepitaxial or heteroepitaxial reactor.

### BACKGROUND OF THE DISCLOSURE

Semiconductor layers made by epitaxial growth, also known as epilayers, are formed by epitaxial deposition in the reaction chamber of a reactor. The deposited material may be the same as the substrate or involve different semiconductors with specific desirable qualities. Epitaxial techniques allow to control the crystal structure formed over the substrate and to improve the epilayer surface features, making them suitable for manufacturing complex microprocessors and memory devices.

Typically, the reaction chamber is heated to a desired temperature before deposition, and the temperature is maintained substantially constant throughout the deposition process. To this effect, insulating systems are used to reduce the energy required to achieve and maintain the nominal temperature of the deposition process.

The ability to maintain a controlled temperature in time, during the deposition process, and from run to run, impacts on the quality of the film's growth.

However, also other temperature-related parameters affect the deposition process. Indeed, it has been observed that local temperature variations on the deposition surface of the substrates heavily affect the quality of the deposited films.

Reaction chamber type (single wafer versus batch), reaction chamber design (i.e., horizontal, or vertical flow) and substrate size may influence the overall spatial temperature profile over the substrates to be processed. Typically, the deposition surface of the substrates is subject to a temperature gradient, which may produce undesired effects, including doping inhomogeneity, growth deviations and other defects.

While some reaction chamber designs known in the art (such as the single wafer, horizontal, cross-flow chamber disclosed in EP4065747) exhibit improved temperature gradients on the substrate, they do not allow to measure such gradient or to directly monitor the temperature of the deposition surface of the substrates in real-time, for optimization of process conditions/design, or to follow run-to-run changes.

In general, the constraints imposed by the reaction chamber design, its high operating temperature and the presence of corrosive process gases, make it difficult to accurately measure the temperature of the substrates in real time, on one or more points of their deposition surface.

For instance, in case of epitaxial reactors for the deposition of silicon carbide, the temperature within the cavity of the chamber lies in the 1400 - 1750°C range, and the growth of parasitic SiC build up on chamber parts exposed to the process gases adds a further layer of complexity, as deposits may obstruct any smaller holes manufactured on the walls of the chamber, to allow remote sensing thermometers to directly point at the substrates. Larger holes may on the other hand affect the temperature profile within the reaction chamber.

It is therefore desirable to provide a device and system adapted to measure the temperature of the deposition surface of a substrate, in-situ and during deposition, especially in case of a hot wall reactor for the deposition of silicon carbide.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention to overcome the disadvantages of the prior art.

In particular, it is an object of the present invention to provide a temperature monitoring device and a temperature monitoring system incorporating said device, adapted to measure the temperature of one or more points of the deposition surface of a substrate in a reactor, during the deposition process.

It is a further object of the present invention to provide a reactor for the deposition of silicon carbide provided with the above temperature monitoring device and/or temperature monitoring system.

The main objectives hereinbefore described are achieved through the invention recited in the appended claims, which constitute an integral part of the present description.

It is noted that the use of reference signs in the claims, if any, does not limit their scope. The sole purpose of reference signs is to make the claims easier to understand.

### BRIEF DESCRIPTION OF THE FIGURES

The illustrations presented herein are not meant to be actual views of any particular material, structure, or device, but are merely idealized representations that are used to describe embodiments of the disclosure.
FIG. 1 schematically illustrates a temperature monitoring system in accordance with one embodiment of the invention.
FIG. 2 provides a simplified illustration of a reactor in accordance with one embodiment of the invention.
FIG. 3 schematically illustrates a temperature monitoring device in accordance with one embodiment of the invention.
FIG. 4 schematically illustrates the operation of a data acquisition system of the temperature monitoring device according to an embodiment of the invention.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure.

It will be appreciated that elements in the figures are illustrated for simplicity and clarity. In particular some elements may have been omitted or may have not necessarily been drawn to scale. For example, the dimensions of some of the elements in the figures may be exaggerated relative to other elements to help improve understanding of illustrated embodiments of the present disclosure.

Under an aspect, the present invention relates to a temperature monitoring device 100 comprising at least one optical device 104, at least one remote sensing thermometer 102, and a supporting device 130; with the supporting device 130 being adapted to support the optical device 104 and comprising a retractable element 132 integral with the optical device 104.

The remote sensing thermometer includes at least one detector of IR radiation adapted for temperature measurements.

The optical device is adapted to reflect, refract, or in any case divert the optical path of IR light from a first direction to a second direction different from the first, thus allowing IR radiation from an out-of-sight spot to reach the IR detector thanks to the change of direction imparted by the optical device. By "out-of-sight" it is meant that the spot of interest is out of the field of view of the detecter.

"Remote sensing thermometer" refers to an instrument adapted to measure the temperature of an object in a contact-less fashion, such as a thermographic camera, a thermocouple or a pyrometer. In the context of the present invention, the remote sensing thermometer shall be chosen suitable to measure the temperature of a substrate in a reaction chamber during deposition. When the instrument is used in a SiC reactor, for instance, the remote sensing thermometer shall be configured to measure temperatures up to 1750 °C.

"Supporting device" refers to a device suitable to support and optionally protect the optical device. The supporting device may be made of quartz, stainless steel and/or graphite. For instance, the supporting device may comprise an external enclosure made of stainless steel or graphite and have the retractable element made of graphite or quartz.

In a non-limiting but preferred example, the optical device is a prism or a mirror, suitable to operate at temperatures between 1400-1750°C. For example, a sapphire prism has been found to work particularly well in the execution of the invention.

The temperature monitoring device is a composite instrument for remote temperature measurements, particularly useful in instances where a remote sensing thermometer cannot directly point and measure the temperature of an object of interest, for instance due to space constraints or other ambient conditions.

The temperature monitoring device according to the invention is especially useful when the overall encumbrance of the device needs to be easily modifiable to accommodate different operations of the system it is embedded into.

The temperature monitoring device according to the invention may be advantageously used in a system for measuring in-real time the temperature of the deposition surface of a substrate in the reaction chamber of a reactor, when the latter is in operation.

As will become apparent in the following, the temperature monitoring device 100 according to the invention may comprise several optional advantageous features, whether considered alone or embedded into a temperature monitoring system. For brevity, such features are described in connection with the latter, though they may be successfully implemented in the temperature monitoring device itself.

Under an aspect, the invention relates to a temperature monitoring system 50 for measuring the temperature of a substrate 10 during the deposition process of a reactor 1.

The temperature monitoring system includes: (i) at least one reaction chamber 500 of a reactor suitable for the deposition of a film on a deposition surface of a substrate, and (ii) at least one temperature monitoring device 100.

Specifically, "reaction chamber" refers to the one or more parts of a reactor where the reaction and deposition of films on the deposition surface of a substrate takes place.

Typically, the reaction chamber defines at least one (partially or completely) enclosed space, formed by one or more walls, suitable for the flow of process gases over a substrate. Typically, the walls of the reaction chamber will be provided with one ore more apertures, such as inlets and outlets for gas flow.

Typically, the substrate is positioned within a receiving area of the reaction chamber enclosure adapted to receive and rotate at least one substrate placed on a substrate holder.

"Deposition surface" refers to the surface of the substrate exposed to process gases during a specific deposition cycle, i.e., the surface where a deposited film grows during said cycle.

The temperature monitoring device includes at least one optical device 104, at least one remote sensing thermometer 102, and a supporting device 130.

The supporting device is adapted to support the optical device and includes a retractable element 132 integral with the optical device 104.

The reaction chamber is provided with at least one aperture 106. Preferably, the aperture is a gas inlet or a gas outlet.

The optical device intercepts IR radiation emitted from the point of interest through the aperture 106 and diverts the intercepted IR radiation to the detector.

This assembly allows the temperature monitoring device to measure the temperature of at least one point of interest of the deposition surface of the substrate placed out of the line of sight of the remote sensing thermometer.

"Optical device" refers to any device adapted to reflect, refract, or otherwise divert the optical path of IR light from a first direction to a second direction different from the first, under certain conditions of inclination of the device with respect to the first direction and wavelength of incoming radiation.

The temperature monitoring system hereinbefore described is an assembly suitable to measure, monitor and/or scan in real time the temperature of the deposition surface of a substrate inside a reaction chamber, during the reaction and deposition process.

Advantageously, the temperature monitoring system of the invention allows to overcome some spatial constraints of measuring the temperature of a substrate inside a reactor. The presence of the optical device allows the remote sensing thermometer to be placed out of the line of sight of the point of interest to be measured, thereby providing a compact design.

The retractable element is an element adapted to move along at least one predefined direction. It may be an arm, probe, or a more complex telescopic mechanism.

The retractable element advantageously allows to displace the optical device for routine maneuvers, such as access to parts or substrates inside the reaction chamber, and/or to intercept IR radiation from different points of interest of the deposition surface of the substrates.

Under an embodiment, the remote sensing thermometer is an infrared pyrometer, preferably adapted for spot temperature measurements.

Under an embodiment, the remote sensing thermometer comprises a light source. The light source emits a light beam 114 in the visible range to highlight the point of interest being measured.

Advantageously, the light beam provides a visible indicator of the optical path of radiation from the substrate to the remote sensing thermometer, thereby facilitating the correct positioning of the temperature monitoring device 100 with respect to the reaction chamber 500 and the substrate 10. Preferably the light source is collimated. Even more preferably, the light source is a laser.

Under an embodiment, the supporting device 130 comprises a cooling system 112.

Advantageously, the cooling system 112 allows to protect the temperature monitoring device from the heat of the reaction chamber 500 and preserve its parts.

To further protect the temperature monitoring device from high temperatures, the retractable element 132 can be made of graphite or quartz.

The supporting device may also enclose the optical device, in toto or in part, and feature an opening 134. The opening 134 is adapted to allow IR and optionally visible radiation to reach (or reflect/refract from) the optical device from the deposition surface.

Advantageously, under the above embodiment the optical device is protected by the enclosure of the supporting device.

Under an embodiment, the supporting device is adapted to displace the optical device along a predefined direction, preferably said predefined direction is substantially perpendicular to the deposition surface of the substrate.

Advantageously, this design allows to limit the encumbrance of the temperature monitoring system.

Under an embodiment, the supporting device 130 is adapted to displace the optical device 104 from a position A to a position A' different from A.

In position A, the optical device is adapted to divert the intercepted IR radiation emitted from a first reference point of the deposition surface of the substrate 10 to the detector through the aperture 106.

In position A', the optical device is adapted to divert the intercepted IR radiation emitted from a second reference point of the deposition surface of the substrate to the at least one detector through the at least one aperture. The second reference point is different from the first.

Advantageously, the above configuration allows to monitor in real time the temperature of at least two different points of interest located on the deposition surface of the substrate.

The measurements above allow to evaluate the temperature variation between different refence points of the deposition surface. To this effect it may be convenient to choose the center point and the upstream peripheral point of the substrate as the first and second points of interest to be measured. Optionally, also the downstream peripheral point can be measured, as well as any plurality of intermediate points in between.

"Center point" refers to the geometrical center of the deposition surface of the substrate. In case of a substrate of circular shape, it coincides with the center. For any other generic shape, the center point coincides with the centroid.

The terms upstream and downstream are meant in respect of the flow of process gases in the reaction chamber.

Under an embodiment, the supporting device is configured to displace the optical device in a direction perpendicular to the deposition surface of the substrate, to continuously scan the temperature of the deposition surface along a plurality of points, preferably said plurality of points includes the center point and at least one peripheral point of the deposition surface of the substrate, preferably the at least one peripheral point is the upstream peripheral point.

The above embodiment allows measuring the temperature gradient of the deposition surface of the substrate, which provides detailed and useful diagnostic information and allows undertaking corrective actions if needed.

Under an embodiment, the supporting device is configured to displace the optical device from a position A to a position B different from A.

In position A, the optical device is adapted to divert the IR radiation emitted from a first reference point of the deposition surface of the substrate to the detector through the aperture.

In position B, the optical device is out of the line of sight of any and all points of the deposition surface of the substrate. Thus, in position B the optical device does not intercept any IR radiation emitted from the substrate.

Advantageously, according to this embodiment, the optical device is adapted to be completely retracted with respect to the aperture 106 and allows easy access inside the reaction chamber and/or further protection of the optical device when not in use.

Under an embodiment, the remote sensing thermometer 102 is adapted to be displaced along a predefined trajectory in order to scan the temperature of the deposition surface along a plurality of points, including at least the center point and at least one peripheral point of said deposition surface.

The above embodiment may be advantageously used in alternative to displacing the optical device for scanning the deposition surface of the substrate. Depending on the constraints imposed by the reaction chamber, one embodiment may be preferred over the other, or they may be combined together.

Under an embodiment, the at least one aperture 106 is an aperture configured or configurable to discharge exhaust gases out of the reaction chamber. For instance, it may be an outlet for exhaust gases.

Advantageously the outlet for exhaust gases is often an established feature of a reaction chamber, it is sufficiently large gap in the enclosure to allow a broad field of view inside the chamber without compromising its thermal profile.

Under an embodiment, the temperature monitoring device is connected or connectable to a gas source 110.

The gas source is adapted to flow a gas between the optical device 104 and the substrate, preferably between the optical device and the aperture 106, even more preferably between the optical device and the opening 134, if present.

The flow of gas from the gas source 110 advantageously protects the optical device from contamination by the exhaust gases and/or from the heat.

Advantageously, the gas source may be a source of inert gas, preferably argon, or hydrogen.

Under an embodiment, the temperature monitoring device is adapted to convert the temperature measured by the remote sensing thermometer into a first electrical signal, i.e., a temperature signal.

Additionally, the temperature monitoring device comprises:
- a data acquisition system adapted to acquire the first electrical signal and convert it into a first set of digital numeric values; and
- an accessible memory and a processor adapted to process the first set of digital numeric values.

Advantageously, in this embodiment the remote sensing thermometer also performs as first temperature sensor of the data acquisition system. The processor of the data acquisition system or an optional CPU connected thereto, may for instance process the digital numerical values by checking them against a set of benchmark values, and activate further controls, such as increasing or decreasing the power of the heating system of the reactor in response to the temperature readings by the remote sensing thermometer.

The data acquisition system may optionally comprise a user interface, to receive inputs or display numeric values or other related information of interest, and/or a non-volatile memory for storing the numeric values for future reference or use.

The temperature monitoring device may further comprise a position sensor 402 adapted to: (i) measure the position of the optical device; and (ii) convert it into a second electrical signal, which is a position signal.

In the present embodiment, the data acquisition system is adapted to acquire the second electrical signal and to convert it into a second set of digital numeric values. Furthermore, the processor is adapted to process the second set of digital numeric values, and to associate them to the first set of digital values. This allows to associate the temperature measurement with the position of the optical device, and indirectly, to the point(s) of the deposition surface being measured. The processor of the data acquisition system or an optional CPU connected thereto, may for instance activate the scanning of the deposition surface of the substrate via a user input from a user interface or through a predefined program. The scanning of the deposition surface may include, for instance, the center point and the upstream and downstream peripheral points of the substrate.

Depending on the outcome results, a user or a computer program may activate controls imparting suitable changes to the flow rate of process gases, the power of the heating system, and/or the pressure inside the chamber.

In addition, or in alternative to the above, a user or a computer program may under predefined or desirable conditions activate the complete retraction of the optical device in a position which is out of the line of sight of any and all points of the deposition surface of the substrate

This may facilitate access to the substrate or the reaction chamber inner walls through the aperture 106.

Under an embodiment, the reaction chamber is a hot wall, crossflow chamber adapted for the epitaxial deposition of silicon carbide films on a substrate.

Under an aspect, the present invention relates to a reactor 1 for the deposition of films, preferably semiconductor films, on the deposition surface of a substrate 10.

The reactor comprises:
- the temperature monitoring system 50 according to any of the embodiments, taken alone or in combination, hereinbefore described; and
- an insulating system surrounding the reaction chamber; and
- a heating system 200 surrounding the insulating system.

The temperature monitoring device of the reactor 1 is adapted to measure the temperature of one or more points of the deposition surface of the substrate in real-time, during operation.

Advantageously, the reactor according to the invention allows in-situ measuring, and optionally scanning, of the temperature on the deposition surface of a substrate, during the epitaxial deposition process.

In a particularly advantageous embodiment, the reactor is an epitaxial reactor for the deposition of silicon carbide. In this case the temperatures within the cavity of the chamber may be in the 1400 - 1750 °C range. These temperatures may be reached in many ways and the chamber may be of the "hot-wall" or "cool-wall" type. In the former preferred example, the walls of the reaction chamber, as well as the enclosed cavity, typically reach high deposition temperatures. These parts may be effectively heated via induction means. In this case, the reaction chamber may comprise one or more structural parts, such as one or more walls, made of a susceptive material, for example graphite.

The reaction chamber may additionally comprise other susceptive functional parts, such as graphite substrate holders, rings, and upstream and downstream cover elements.

The heating system may comprise one or more induction coils.

The insulating system may comprise one or more covers made of a thermally insulating material. To this effect, porous carbonaceous materials can be used, for instance carbon composites made from short cut carbon fibers, optionally interconnected in a matrix or pressed together.

The reactor may also comprise an external jacket wrapped around the reaction chamber, positioned between the latter and the heating system. The external jacket may limit the heat irradiated by the reaction chamber into the surrounding environment. The external jacket may be a double wall quartz tube, cooled with a cooling fluid such as water.

It is understood that the reactor according to the invention will implicitly include any other suitable additional elements, such as pumps, valves, gas panels, and circuitries to ensure its correct operation.

The subject matter of the present disclosure includes all novel and nonobvious combinations and sub-combinations of the various processes, systems, and configurations, and other features, functions, acts, and/or properties disclosed herein, as well as any and all equivalents thereof.

### DETAILED DESCRIPTION OF THE DRAWINGS

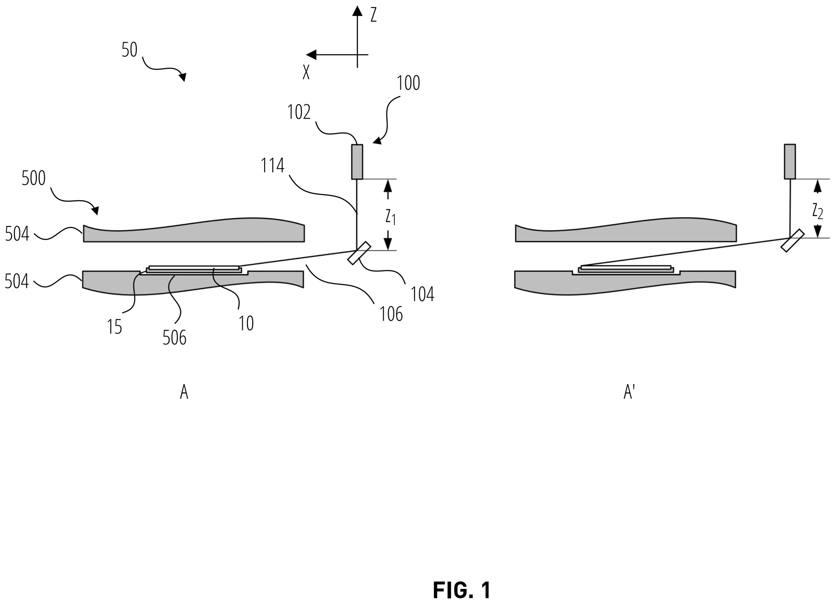

FIG. 1 provides a simplified illustration of the temperature monitoring system 50 in two different configurations A and A', which allow to measure the temperature of two different points of interest on the deposition surface of the substrate 10. For clarity, reference numbers are provided only for configuration A.

In both configurations A and A', the system comprises a temperature monitoring device 100 and a reaction chamber 500, of which a simplified sectional view along the longitudinal direction X is provided. The reaction chamber comprises an upper chamber part 504, a lower chamber part 502, and an aperture 106. The lower chamber part 502 comprises a receiving area 506 suitable to receive a substrate holder 15 with a substrate 10 supported therein.

The temperature monitoring device 100 comprises a remote sensing thermometer 102, such as a pyrometer, and an optical device 104, such as an IR-vis mirror. The temperature monitoring device 100 also comprises a supporting device, not shown, such as an arm to support the optical device. The light beam 114 visually illustrates the optical path to/from the deposition surface of the substrate from/to the detector of the temperature monitoring system. It can be seen that in configuration A and A' the detector measures different spots of the deposition surface, as the optical device moves in the vertical direction Z, perpendicular to X, from a position z₁ to a position z₂.

It is understood that the same effect can be obtained by keeping the optical device at a predetermined height and either rotate the optical device (for example about an axis perpendicular to both X and Z and centered where the reflection occurs), or rotate the remote sensing thermometer in order to assess the temperature of different spots of the deposition surface.

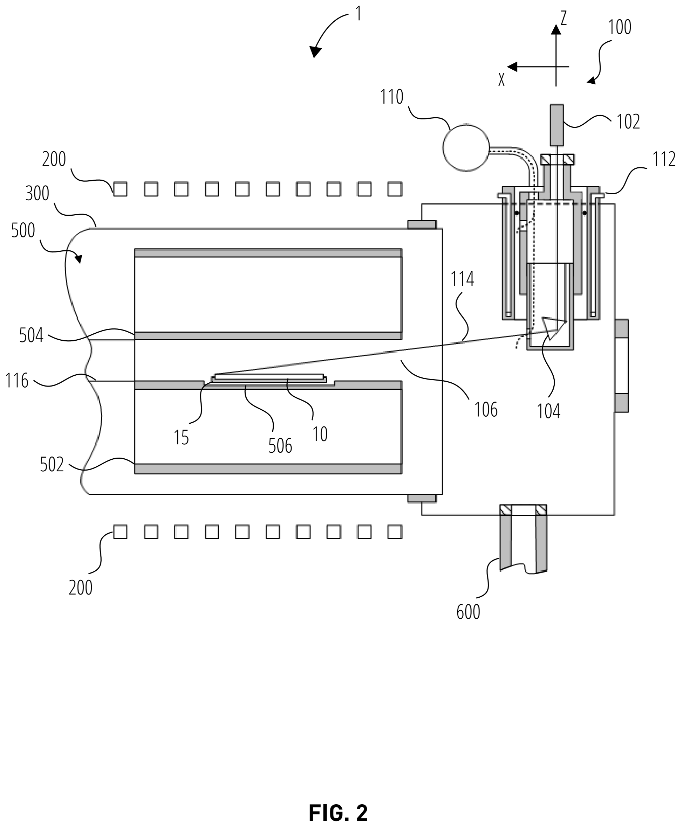

FIG. 2 illustrates a reactor 1 comprising a temperature monitoring system. The latter features a temperature monitoring device 100 and a reaction chamber 500.

The reaction chamber 500 includes an external jacket, i.e., the quartz tube 300 enclosing a lower chamber part 502 and an upper chamber part 504. These parts are made of graphite and suitable to be heated by induction means. The parts 502 and 504 extend along a longitudinal direction x and feature a half-moon shape in a plane transverse to the longitudinal direction, as depicted in FIG. 2 of EP4065747.

The lower chamber part 502 features a receiving area 506 adapted to receive and rotate a substrate holder 15 supporting a substrate 10.

In the present configuration, process gases may enter the reaction chamber 500 through the liner 116, in a crossflow configuration. In this case, the deposition surface of the substrate 10 is the surface directly facing the upper chamber part 504. Exhaust process gases may exit the reaction chamber through the aperture 106.

The reaction chamber also comprises lateral walls extending along the longitudinal direction and an insulating system (not shown) positioned between the chamber parts and the quartz tube 300.

The temperature monitoring device 100 comprises an optical device 104 and a remote sensing thermometer 102 having an IR detector (not shown). The optical device in this case is a sapphire prism suitably oriented to receive a beam of IR light from one spot of the deposition surface of the substrate 10, along a first direction. Upon hitting the first internal surface of the prism, the beam of IR light travels along a second direction, different from the first one, to hit an IR detector housed inside the remote sensing thermometer. This allows measuring the temperature of the above-mentioned one spot.

A light beam 114 emitted from a laser light source (not shown) contained in the remote sensing thermometer allows to visually align the temperature monitoring device with the substrate. The path of the light beam 114 is indicative of the path of the IR light from the deposition surface of the substrate, albeit travelling in opposite direction.

The orientation of the optical device can be configured to measure the temperature of different spots of the deposition surface of the substrate depending on its position along a vertical direction z, perpendicular to the longitudinal direction x and to the deposition surface.

The temperature monitoring device 100 is connected to a gas source 110 for supplying a flow of argon in front of the optical device, between the latter and the aperture 106. The argon flow allows to protect the optical device from the heat of the reaction chamber and from stains and deterioration due to the exposure to exhaust gases from the reaction chamber.

The temperature monitoring device 100 comprises a cooling system 112.

The cooling system comprises a serpentinite channel, carved out or machined in the outer walls of the supporting device 130, and adapted to flow a cooling gas or a cooling fluid to control the temperature of the temperature monitoring device.

The reactor 1 also features an exhaust line 600 to collect the exhaust gases from the outlet aperture 106 to a scrubber (not shown) and an induction coil (the heating system 200) wrapped around the quartz tube 300.

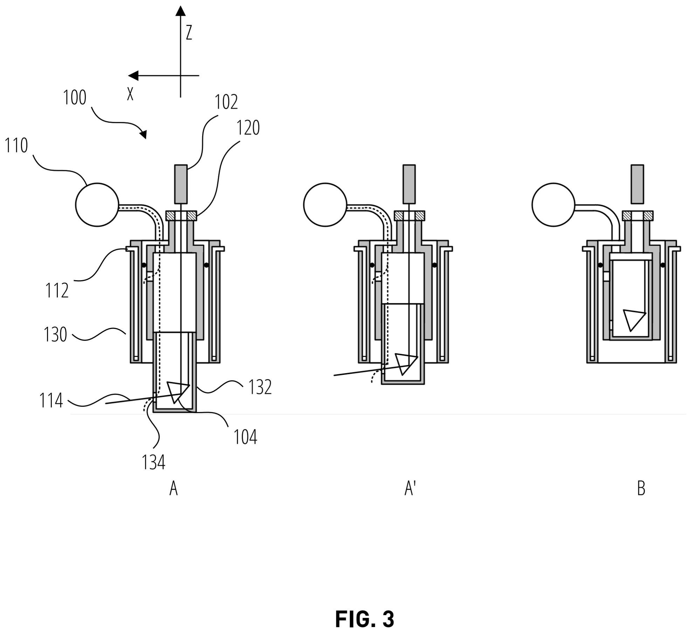

FIG. 3 provides a simplified sectional view in the XZ plane of the temperature monitoring device 100 in three different configurations A, A' and B.

In all configurations the temperature monitoring device includes a remote sensing thermometer 102 having an IR detector (not shown), a prismatic optical device 104, a retractable element 132, and a viewport 120.

The temperature monitoring device 100 is connected to a gas source 110 adapted to provide a flow of argon (dashed line) in front of the optical device 104, to protect the latter from the exhausts and the heat.

The temperature monitoring device 100 according to this embodiment also includes a cooling system 112, adapted to flow a cooling fluid in a serpentine conduit manufactured within the outer walls of the supporting device 130. The latter also includes a retractable element 132 suitable to displace the optical device 104 in the vertical direction Z, to reach three different configurations A, A' and B.

The retractable element also includes an opening 134 to allow the IR radiation from the substrate to reach the optical device 104.

In configuration B the optical device and the retractable element 132 are completely retracted within the supporting device 130.

In configuration A, and A', the optical device is positioned at a different height in the vertical direction Z so as to receive IR light from different source points at a same angle, and redirect it to the detector along one same (vertical) direction z. The optical path is exemplified by the light beam 114, which is a laser beam emitted by the remote sensing thermometer for alignment purposes.

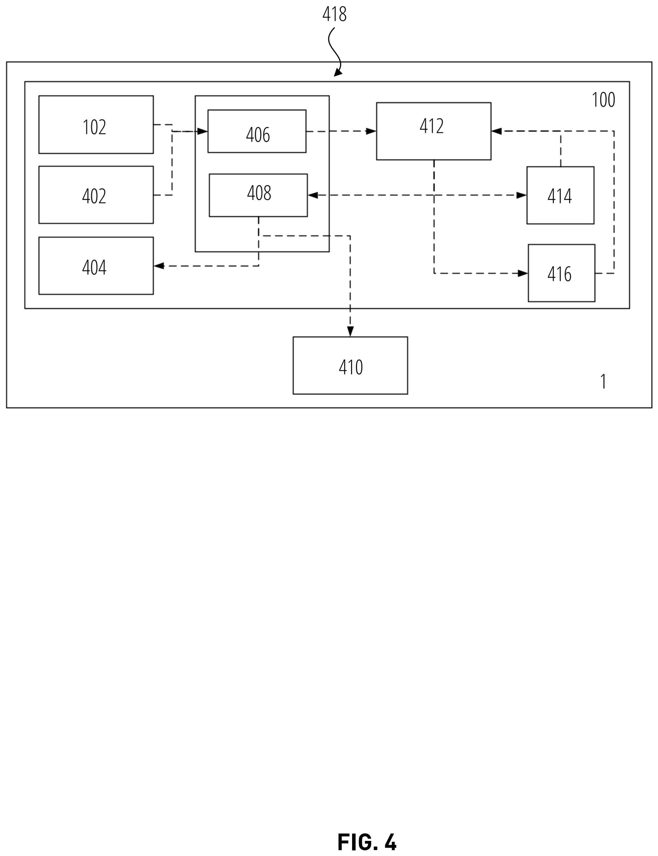

FIG. 4 schematically illustrates a data acquisition system 418 of a temperature monitoring device 100, as used in the reactor 1.

In this embodiment, the data acquisition system comprises two sensors: (i) the remote sensing thermometer 102; and (ii) an optional position sensor 402, which measures the position of the optical device (not shown) of the temperature monitoring device with respect to a predefined reference. The two sensors deliver their respective temperature and position signals to an input card 406, which converts the signals into two sets of digital numeric values. These digital numeric values are sent to a CPU 412.

The CPU may include an accessible memory and a processor.

The CPU communicates with an optional UI 414, and an optional non-volatile memory 416. The UI may display relevant information to a user, and/or receive inputs therefrom.

CPU and UI respectively refer to a central processing unit and a user interface.

The non-volatile memory may store information on the measured values and/or user inputs for future reference.

The CPU may deliver any processed signals/commands to an output card 408.

The CPU may associate temperature and position values provided by the sensors so as to depict the temperature variation across different points of the deposition surface of the substrate.

The output card 408 is connected to an optional first actuator 404.

By "actuator" it is meant a system adapted to actuate an instruction, for instance an instruction from an output card.

For example, the first actuator 404 may command the displacement of the optical device to measure the temperature of a different spot on the deposition surface of a substrate.

In addition, or in alternative, the first actuator 404 may also regulate the flow of inert gas in front of the optical device from the gas source (not shown).

The first actuator will typically control parts belonging to the temperature monitoring device.

The output card 408 is also connected to an optional second actuator 410. The second actuator may control reactor parts such as the heating system and/or a flow regulator controlling the flow of process gas inside the reaction chamber. It may also control the pressure inside the reaction chamber of the reactor. These parameters may allow to correct the temperature and/or the temperature gradient on the deposition surface of the wafer, according to suitable calibration curves.

## Claims

1. A temperature monitoring system for measuring the temperature of a substrate during the deposition process of a reactor; wherein said temperature monitoring system comprises:
- at least one reaction chamber of a reactor, suitable for the deposition of a film on a deposition surface of a substrate;
- at least one temperature monitoring device comprising at least one optical device, at least one remote sensing thermometer, and a supporting device;
wherein the supporting device is adapted to support the at least one optical device and comprises a retractable element integral with said optical device;
wherein the remote sensing thermometer comprises at least one detector of IR radiation adapted for temperature measurements, and wherein the reaction chamber is provided with at least one aperture; the at least one optical device being adapted to:
- intercept IR radiation emitted from at least one point of the deposition surface of the substrate through the at least one aperture; and
- divert the intercepted IR radiation to the at least one detector;
in order to measure the temperature of said at least one point of the deposition surface with said remote sensing thermometer.

2. The temperature monitoring system according to claim 1, wherein the remote sensing thermometer is a pyrometer preferably adapted for spot temperature measurements.

3. The temperature monitoring system according to claim 1 or 2, wherein the remote sensing thermometer comprises a light source; wherein said light source emits a light beam to highlight the at least one point of the deposition surface of the substrate emitting the IR radiation being measured.

4. The temperature monitoring system according to any one of claims 1 to 3, wherein the supporting device comprises a cooling system.

5. The temperature monitoring system according to any one of claims 1 to 4, wherein the supporting device is adapted to displace the optical device along a predefined direction, preferably said predefined direction is substantially perpendicular to the deposition surface of the substrate.

6. The temperature monitoring system according to any one of claims 1 to 5, wherein the supporting device is provided with an opening and the optical device is enclosed, in toto or in part, within the supporting device.

7. The temperature monitoring system according to any one of claims 1 to 6, wherein the retractable element is made of graphite.

8. The temperature monitoring system according to any one of claims 1 to 7, wherein the supporting device is adapted to displace the optical device from a position A to a position A' different from A; so that:
- in position A, the optical device is adapted to divert the intercepted IR radiation emitted from a first reference point of the deposition surface of the substrate to the at least one detector through the at least one aperture; and
- in position A', the optical device is adapted to divert the intercepted IR radiation emitted from a second reference point of the deposition surface of the substrate to the at least one detector through the at least one aperture; wherein said second reference point is different from the first.

9. The temperature monitoring system according to any one of claims 1 to 8, wherein the supporting device is configured to displace the optical device from a position A to a position B different from A; wherein:
- in position A, the optical device is adapted to divert the IR radiation emitted from a first reference point of the deposition surface of the substrate to the at least one detector through the at least one aperture; and
- in position B, the optical device is out of the line of sight of any and all points of the deposition surface of the substrate.

10. The temperature monitoring system of any one of claims 1 to 9, wherein the supporting device is configured to displace the optical device in a direction perpendicular to the deposition surface of the substrate to continuously scan the temperature of the deposition surface along a plurality of points, preferably said plurality of points includes a center point and at least one peripheral point of the deposition surface of the substrate, preferably the at least one peripheral point is the upstream peripheral point.

11. The temperature monitoring system according to any one of claims 1 to 10, wherein the at least one optical device is a prism or a mirror suitable to operate at temperatures between 1400-1750 °C.

12. The temperature monitoring system according to any one of claims 1 to 11, wherein the remote sensing thermometer is adapted to be displaced along a predefined trajectory in order to scan the temperature of the deposition surface along a plurality of points, including at least the center point and at least one peripheral point of said deposition surface.

13. The temperature monitoring system according to any one of claims 1 to 12, wherein the at least one aperture is an aperture adapted to discharge exhaust gases out of the reaction chamber.

14. The temperature monitoring system according to any one of claims 1 to 13, wherein the temperature monitoring device is connected to a gas source adapted to flow a gas between the optical device and the substrate.

15. The temperature monitoring system of claim 14, wherein the gas source is a source of inert gas, preferably argon, or hydrogen.

16. The temperature monitoring system according any one of claims 1 to 14; wherein the temperature monitoring device is adapted to convert the temperature measured by the remote sensing thermometer into a first electrical signal; wherein the temperature monitoring device further comprises:
- a data acquisition system adapted to acquire said first electrical signal and convert it into a first set of digital numeric values; and
- an accessible memory and a processor adapted to process said first set of digital numeric values.

17. The temperature monitoring system of claim 16; wherein the temperature monitoring device further comprises: a position sensor adapted to measure the position of the optical device and to convert it into a second electrical signal, and the data acquisition system is adapted to acquire said second electrical signal and convert it into a second set of digital numeric values; the processor being adapted to process said second set of digital numeric values, and associate them to the first set of digital values.

18. The temperature monitoring system according any one of claims 1 to 17, wherein the reaction chamber is a hot-wall, cross flow chamber adapted for the epitaxial deposition of silicon carbide films on a substrate.

19. A reactor for the deposition of films on the deposition surface of a substrate comprising:
- the temperature monitoring system according to any one of claims 1 to 18;
- an insulating system surrounding the reaction chamber;
- a heating system surrounding the insulating system;
wherein the temperature monitoring device is adapted to measure the temperature of one or more points of the deposition surface of the substrate in real-time, during reactor operation.

20. A temperature monitoring device comprising:
- at least one optical device;
- at least one remote sensing thermometer comprising an IR detector; and
- a supporting device adapted to support the optical device and comprising a retractable element integral with the optical device;
wherein the optical device is adapted to reflect, refract, or divert the optical path of IR light from a first direction to a second direction different from the first.
